# EUROPEAN PATENT APPLICATION

(11) **EP 4 383 971 A1**
(43) Date of publication of application: **12.06.2024**
(21) Application number: 22020607.2
(22) Date of filing: 09.12.2022
(51) Int. Cl.: H05K 9/00

(54) **PROTECTION SYSTEM AGAINST NON-IONIZING ELECTROMAGNETIC RADIATION USING METAMATERIAL, REINFORCED CONCRETE WITH BUILT-IN STEEL RING MICRORESONATORS, INSTALLING METHOD AND USE**

(71) Applicant: Gra evinski i arhitektonski fakultet Osijek, 31000 Osijek (HR)
(72) Inventor: Varevac, Damir, 31000 Osijek (HR); Milicevic, Ivana, 31000 Osijek (HR); Rupcic, Slavko, 31000 Osijek (HR)
(74) Representative: Pejcinovic, Tomislav

(57) **Abstract**

According to this invention, the solution of protection against non-ionizing electromagnetic radiation is achieved by creating and applying a protection system using a metamaterial consisting of reinforced concrete with built-in steel ring microresonators. Said microresonators (1) are specialy designed and dimensioned to meet the required properties of load capacity and usability, and they are interconnected and connected to the reinforcing mesh (3) by means of plastic clips (2), wherein said system is intended for use in reinforced concrete load-bearing slabs and walls for building constructions, providing the target metamaterial with self-compacting concrete of appropriate strength, reinforcing mesh (3), and said connected microresonators (1), using the self-compacting concrete blocks (4), and using conventional concrete-work afterwards to finish the construction element.

## Description

Electromagnetic (EM) fields occur in nature and humans have been exposed to electric and magnetic fields since the beginning of time. Today, people are almost always surrounded by a complex mixture of electric and magnetic fields. Due to the rapid development of modern technologies, new applications of EM fields are adopted year after year. It is almost impossible to imagine a year without a new application of EM fields for public use. Considering the increasing trend of human exposure to electromagnetic radiation, the awareness of potential health problems began to grow, especially from 1990 onwards. Exposure to EM (electromagnetic) radiation has increased exponentially in recent years. According to a study by Bandar, Carpenter, exposure to electromagnetic radiation around a frequency of 1 GHz increased by 10¹⁸ compared to natural radiation levels. The scientists' opinions about the harmfulness of long-term exposure to non-ionizing electromagnetic radiation on human health are divided and often conflicting. According to a 2012 Bioinitiative report, between 2007 and 2012 there were approximately 1,800 published studies that reported some effects of human exposure to lower frequencies of non-ionizing EM radiation. In the year 2011, the World Health Organization (WHO) classified radio frequency (from 20 kHz to about 300 GHz) as possibly carcinogenic to humans, because of potential health risks. According to the WHO, most consistent reports today relate to childhood leukemia. This is the reason why, in recent years, attempts have been made to limit exposure to electromagnetic radiation by using materials with good shielding properties. Since the long-term effects are not yet clearly established, some countries have introduced regulations and laws that limit and recommend maximum levels of exposure to electromagnetic radiation based on the unexplained effects of long-term exposure to electromagnetic radiation on human health. To comply with these limitations and recommendations, various materials (e.g. fabrics, coatings and wearables) have been designed that have the ability to provide protection against electromagnetic radiation.

In the last few years, the design of load-bearing structural elements (mainly concrete elements) that have the ability to provide high efficiency protection against EM radiation has been the subject of many studies. The material acts as a shield against electromagnetic interference when it limits the entry of electromagnetic fields into space by reflecting or absorbing them using a barrier made of conductive material. Since load-bearing elements such as concrete have a high electrical resistance of about 10⁶-10⁹ Qm, they cannot be used as a material for EM protection.

### State of the Art

There are many systems and applications of metamaterials for protection against electromagnetic non-ionizing radiation, however, the subject of this invention is the proposed system as an inventive novelty because it is conceived as a protective reinforced concrete building element with embedded steel ring microresonators, where the composition of the concrete, the dimensions of microresonators and principles of connecting microresonators to the reinforcing mesh are of importance.

One of the well-known methods of protection against electromagnetic radiation is the use of carrier materials with the addition of conductive fillers that increase the effectiveness of electromagnetic protection. This method of electromagnetic protection has been mostly investigated in concrete-based composites, while there are also a certain number of scientific projects researching the influence of coatings on electromagnetic protection.

Below are some of the existing patent documents that are closest to this invention in terms of the concept of solving the problem or have similar purposes and applications:
CN110707436A (Date of publication: 17 January 2020)

The paper describes the structure of an electromagnetic wave absorber based on a metamaterial that meets the absorption of electromagnetic radiation and the inhibition of broadband radiation in the high-frequency range of 16-21.2 GHz.

The product is based on a multi-layer ring structure and the absorbing characteristics of the material.

CN110165414A (Date of publication: 23 August 2019)

The paper describes a multi-resonant polarized reflective surface for reducing radiation in the communications area.

CN103700951A (Date of publication: 4 February 2014)

The paper describes a two-layer lightweight composite material structure in the form of a split ring structure, where the reflection coefficient of the material absorbs waves and is below negative 10 dB in the range of 7.5 GHz-22 GHz.

CN110994091A (Date of publication: 10 April 2020)

The paper describes a THz tuneable filter based on a meta-surface. The filter contains a number of filter units, each of which has a substrate dielectric layer, a phase change layer and a split ring resonator, arranged in series, and a cylindrical ring body that is equivalent to inductance.

CN105896098A (Date of publication: 24 August 2016)

The paper describes a broadband THz metamaterial multilayer absorber based on multi-resonance absorption superposition. Each metamaterial structural unit includes a circular ring structure.

CN210006924U (Date of publication: 31 January 2020)

The paper describes the meta-surface of a two-frequency c-type split ring resonator of a terahertz ring dipole.

CN206180122U (Date of publication: 17 May 2017)

The paper describes the structure of the terahertz 3 band super material whose elementary cell structure contains a three-layer metal split ring resonator and four layers of polyimide dielectric layer.

### Specification of the invention

According to this invention, the solution to the problem of protection against non-ionizing electromagnetic radiation is achieved by creating and applying a protection system using a metamaterial consisting of reinforced concrete with built-in steel ring microresonators.

As a solution to a technical problem, this invention provides the procedure for installing and connecting microresonators, the concreting procedure after reinforcement and connection, and the purpose of building elements with built-in microresonators.

The purpose of the metamaterial that is presented below is the highly effective protection against electromagnetic radiation, while meeting the required properties of load capacity and usability. The described metamaterial was designed on the basis of calculation and dimensional and parametric adjustment of the dimensions of the microresonators. When designing the protection system, meta and semi-meta materials with SRR particles of different dimensions were analysed to ensure broadband absorption of EM energy. After defining the dimensions and characteristics of microresonators based on computer simulations, test reinforced concrete blocks with built-in microresonators were made. This system is planned for use in reinforced concrete load-bearing slabs and walls. The target material consists of self-compacting concrete of appropriate strength, reinforcing mesh and microresonators. The composition of self-compacting concrete is shown in Table 1, while the properties of chemical additives are shown in Table 2.

**Table 1. The composition of self-compacting concrete**

| SELF-COMPACTING CONVRETE-M0 | | Mass for 1 m² (kg) | |
|---|---|---|---|
| | | % | (kg) |
| Cement | CEM II 42,5R (GRAND Nexe) | | 450,0 |
| Filler | Dolomite flour | | 80,0 |
| Water | Drinking water | | 180,0 |
| Water-cement ratio | 0,40 | | |
| Chemical additives | Energy FM 500 (SP) | 1,00 % | 4,50 |
| | Premadd Stabilizer X (VMA) | 0,25 % | 1,13 |
| Aggregate | 0-2 mm - river sand | 20% | 325,52 |
| | 0-4 mm - dolomite | 35 % | 616,03 |
| | 4-8 mm - dolomite | 20% | 363,38 |
| | 8-16 mm - dolomite | 25 % | 454,22 |
| Total | | | 2474,78 |

**Table 2. Properties of chemical additives**

| Feature | **SP-Energy FM500** | **VMA-Premadd Stabilizer X** |
|---|---|---|
| Shape | Liquid | Liquid |
| Colour | Amber | White |
| Density (kg/L) | 1,08 ±0,02 | 1,04 ± 0,02 |
| pH value | 3,5 ± 2,0 | 7,0 ± 2,0 |

Microresonators 1 that are embedded in concrete block 4 are S235 quality type steel rings. Several types of microresonators 1 were analysed by numerical calculations in the Ansys HFSS software. By varying the dimensions, shapes and layout, the final shape was defined.

The thickness of microresonators 1 is 15 mm. The dimensions, 3D view and manufactured microresonators 1 can be seen in Figures 1-3.

When making an concrete block 4 with built-in microresonators 1, it is necessary to place the microresonators 1 next to each other so they form a kind of a network in which each ring 1 faces the same direction. Figures 4 and 5 show the production of metamaterial 1 on the example of a concrete block 4 in size of 60 cm x 60 cm x 10 cm. On the lower side, after the protective layer, a reinforcing mesh B500 3 is placed, and on top of it the microresonators assembly 1, 2 is placed. The microresonators 1 are interconnected using plastic clips 2 made by a 3D printer. The dimensions of the plastic clips 2 are shown in Figure 7.

The goal of this invention is an easy-to-install and economical system for the protection of human health against the influence of electromagnetic fields, with special attention to sensitive groups of society such as children, young people and people with various chronic diseases.

Specially designed and dimensioned steel rings 1 with a diameter of 9 cm are connected to each other with plastic clips 2, so they form a kind of a mesh that is then connected to the reinforcing mesh 3 in building construction structures, and such built-in assembly 1, 2, 3, 4 of microresonators 1, clips 2, and reinforcement 3 is filled with building concrete 4 in the usual known manner.

The proposed invention reduces the penetration of electromagnetic radiation into the areas for living, in such a way that the protection with microresonators 1 is an integral part of the building structure, for example a wall or a ceiling, and not as an additional coating.

The system of presented invention targets radiation from radio waves and mostly radiation from mobile phone networks. It has been shown that in this way we can dampen the electromagnetic field by 10-20 dB.

A further object of the proposed invention is to be relatively inexpensive and easy to install and build-in.

Based on laboratory research and measurements, it has been shown that the protection system based on the invention gives the best results for reinforced concrete bearing walls and ceiling bearing slabs.

### Brief description of the drawings and pictures

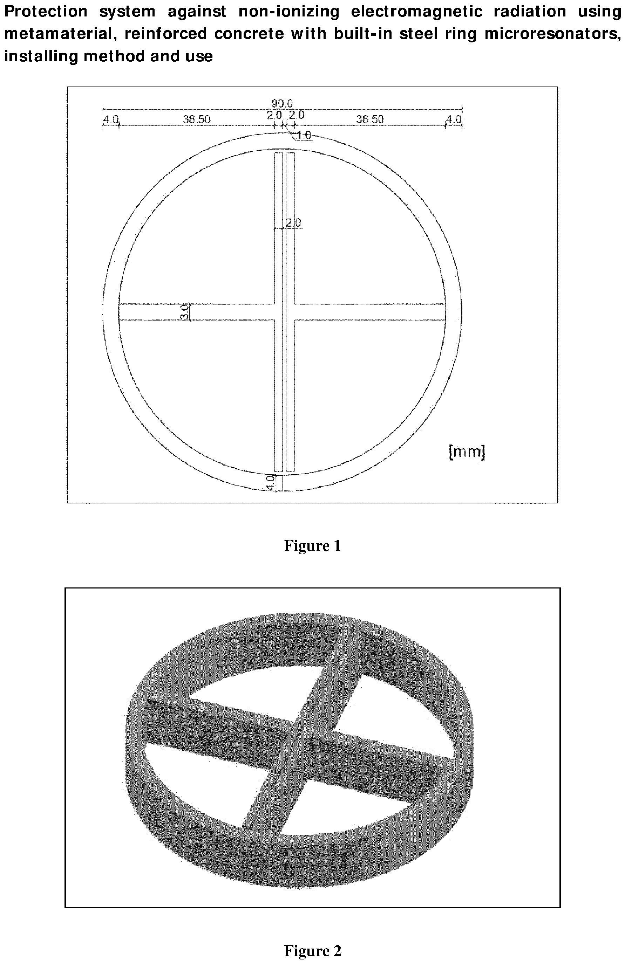

- Figure 1:: dimensions of the microresonators
- Figure 2:: 3D view of the microresonator

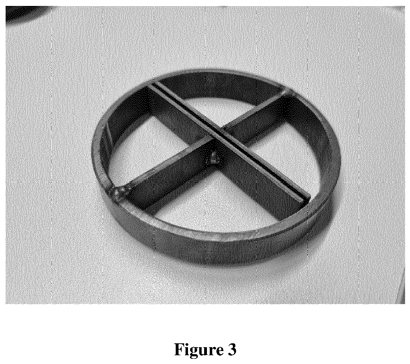

- Figure 3:: photograph of the microresonator

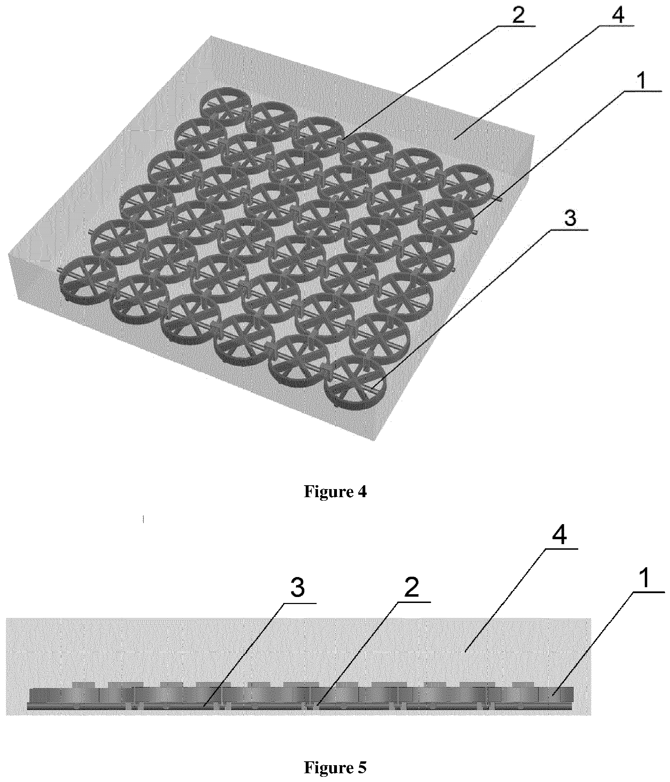

- Figure 4:: 3D example of making concrete lining from metamaterial
- Figure 5:: cross-section of a concrete block made of metamaterial

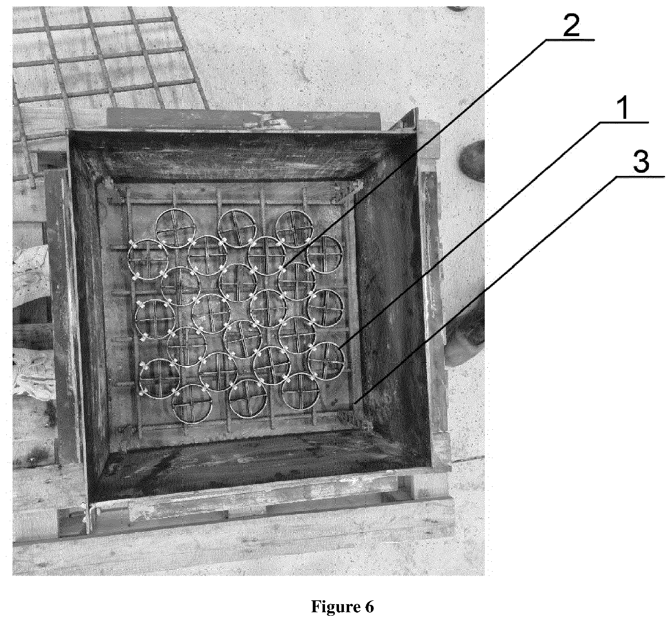

- Figure 6:: the process of making a concrete block with metamaterial

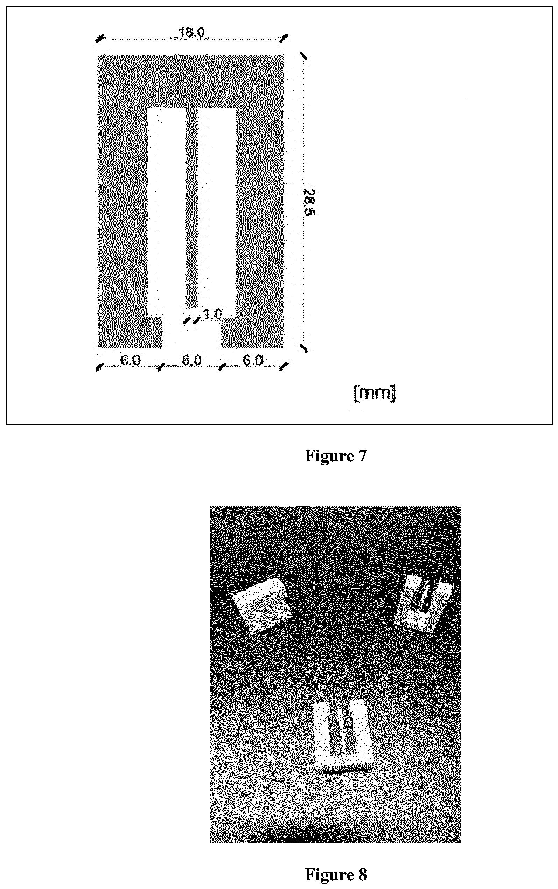

- Figure 7:: dimensions of plastic clips for connecting microresonators
- Figure 8:: 3D view of plastic clips

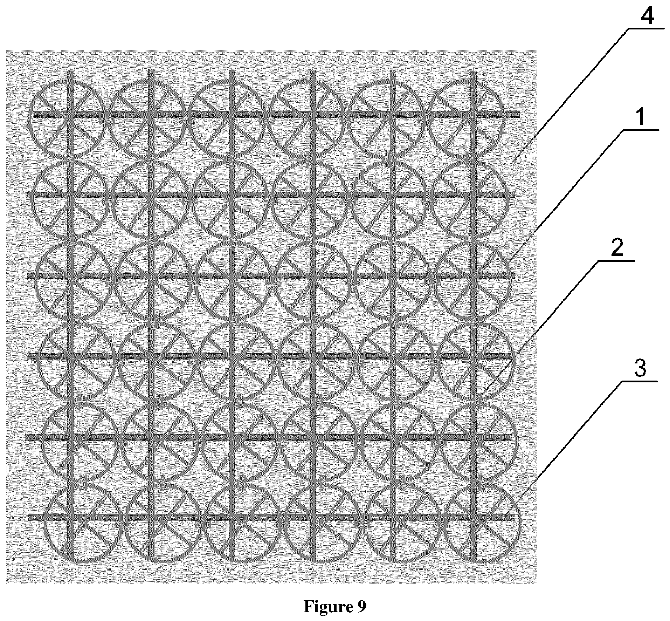

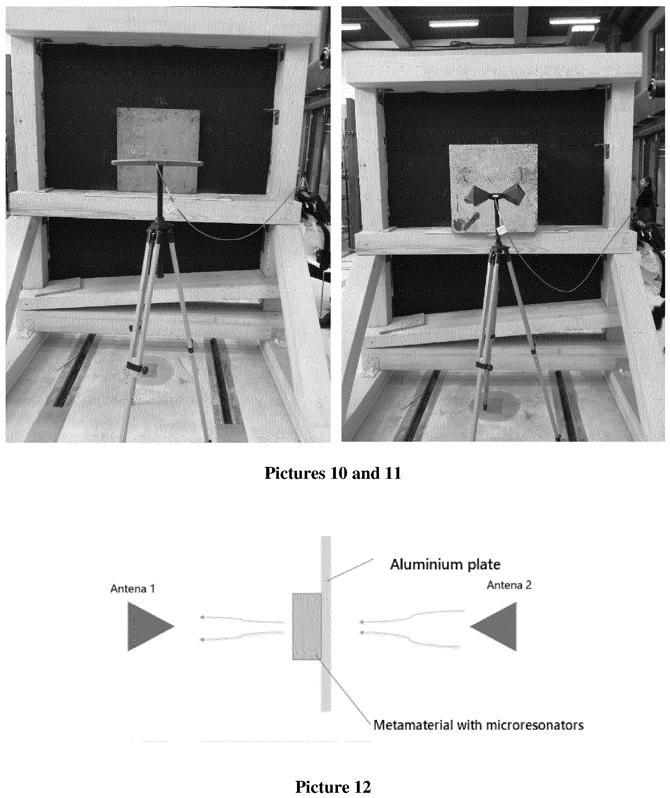

- Figure 9:: 3D view of the metamaterial system together with the clips and reinforcing mesh

Picture 10 and 11: measurement of S21 transmission coefficients using two types of antennas:
a) BicoLOG30100, AARONIA - biconical antenna
b) HyperLOG 30200, AARONIA - logarithmic-periodic antenna

Picture 12: schematic setup of the experiment for determining the degree of radiation protection.

### List of reference numericals

1 microresonator
2 plastic clips
3 reinforcing mesh B500
4 self-compacting concrete block

### Laboratory measurement of radiation protection

To measure the protection, the most common way of determining SE was used by measuring the transmission parameters of S21 (or S12) parameters. In such a measurement, in addition to the transmission parameters, the reflection parameters (S11 and S22) are also measured, which can give us information about the part of the energy of the EM wave that is reflected on the barrier. Concrete test specimens are placed on a wooden support as shown in Pictures 10 and 11. The carrier is covered with an aluminium plate that is coated with an agent to improve reflection directly to the concrete block. Electromagnetic radiation was emitted from antenna 2. Antenna 1 recorded transmission parameters, while antenna 2 recorded reflection parameters, Picture 12. Transmission and reflection parameters were measured using Vector Network Analyzer Anritsu MS2038C and two types of antennas: biconical antenna - model BicoLOG30100, AARONIA and log-periodic antenna - model HyperLOG 30200, AARONIA. During the measurements, two types of antennas were used: a biconical antenna for measurement in the frequency range from 30 MHz to 1 GHz, and a logarithmic antenna for the frequency range of 1 GHz to 18 GHz.

### Reference literature

1 W. H. Organization, Establishing a Dialogue on Risks From Electromagnetic Fields, 2002.
2 O. P. Gandhi, Electromagnetic fields: Human safety issues, Annual Review of Biomedical Engineering, vol. 4, pp. 211-234, 2002, doi: 10.1146/annurev.bioeng.4.020702.153447.
3 K. A. Zed, Electromagnetic fields and public health : extremely low frequency fields and cancer, Science & Technology for Society - Japan, no. October 2001. pp. 1-4, 2007. doi: 10.13140/2.1.4943.2960.
4 P. Bandara; D. O. Carpenter, Planetary electromagnetic pollution: it is time to assess its impact, The Lancet Planetary Health, vol. 2, no. 12, pp. e512-e514, 2018, doi: 10.1016/S2542-5196(18)30221-3.
5 B. Working Group, Bioinitiative 2012: A Rationale for Biologically-based Exposure Standards for Low-Intensity Electromagnetic Radiation, pp. 1-1557, 2012.
6 P. Vecchia, Exposure of humans to electromagnetic fields. Standards and regulations, Annali dell'Istituto Superiore di Sanita, vol. 43, no. 3, pp. 260-267, 2007.
7 A. P. Singh et al., Multiwalled carbon nanotube/cement composites with exceptional electromagnetic interference shielding properties, Carbon, vol. 56, pp. 86-96, 2013, doi: 10.1016/j.carbon.2012.12.081.
8 M. Jung; Y. S. Lee; S. G. Hong, Effect of Incident Area Size on Estimation of EMI Shielding Effectiveness for Ultra-High Performance Concrete with Carbon Nanotubes, IEEE Access, vol. 7, pp. 183105-183117, 2019, doi: 10.1109/ACCESS.2019.2958633.
9 M. Ozturk; M. Karaaslan; O. Akgol; U. K. Sevim, Mechanical and electromagnetic performance of cement based composites containing different replacement levels of ground granulated blast furnace slag, fly ash, silica fume and rice husk ash, Cement and Concrete Research, vol. 136, no. July, p. 106177, 2020, doi: 10.1016/j.cemconres.2020.106177.
10 Z. Li; S. Dong; X. Wang; X. Yu; B. Han, Electromagnetic Wave-Absorbing Property and Mechanism of Cementitious Composites with Different Types of Nano Titanium Dioxide, Journal of Materials in Civil Engineering, vol. 32, no. 5, p. 04020073, 2020, doi: 10.1061/(asce)mt.1943-5533.0003133.
11 X. Zhang; W. Sun, Microwave absorbing properties of double-layer cementitious composites containing Mn-Zn ferrite, Cement and Concrete Composites, vol. 32, no. 9, pp. 726-730, 2010, doi: 10.1016/j.cemconcomp.2010.07.013.
12 I. Vrdoljak; D. Varevac; I. Milićević; S. Ćolak, Concrete-based composites with the potential for effective protection against electromagnetic radiation: A literature review, Construction and Building Materials, vol. 326, no. December 2021, 2022, doi: 10.1016/j.conbuildmat.2022.126919.
13 J. Yun; H. I1 Kim, Electromagnetic interference shielding effects of polyaniline-coated multi-wall carbon nanotubes/maghemite nanocomposites, Polymer Bulletin, vol. 68, no. 2, pp. 561-573, 2012, doi: 10.1007/s00289-011-0651-4.
14 S. M. Jeong et al., Development of a wearable infrared shield based on a polyurethane-antimony tin oxide composite fiber, NPG Asia Materials, vol. 12, no. 1, 2020, doi: 10.1038/s41427-020-0213-z.

## Claims

1. Protection system against non-ionizing electromagnetic radiation, **characterized in that** having a metamaterial comprising reinforced concrete and having built-in steel ring microresonators (1) in concrete block (4), wherein said microresonators (1) are specialy designed and dimensioned to meet the required properties of load capacity and usability, and they are interconnected and connected to the reinforcing mesh (3) by means of plastic clips (2), wherein said system is intended for use in reinforced concrete load-bearing slabs and walls for building constructions, providing the target metamaterial with self-compacting concrete of appropriate strength, reinforcing mesh (3), and said connected microresonators (1), using the self-compacting concrete blocks (4) with composition properties shown in Table 1, and using the chemical additives whose properties are shown in Table 2, and using conventional concrete-work afterwards to finish the construction.

2. Protection system according to patent claim 1, **characterized in that** described metamaterial was designed on the basis of calculation, and dimensional and parametric adjustment of the dimensions of microresonators (1) which are intended to be embedded in concrete blocks (4) for building constructions, wherein said microresonators (1) are S235 quality type steel rings, with the thickness of 15 mm, with a diameter of 9 cm, and with other dimensions shown in Figure 1.

3. Protection system according to patent claims 1 and 2, **characterized in that** microresonators (1) are connected to each other by means of the plastic clips (2) which are made by a 3D printer, and the dimensions of the plastic clips (2) are shown in Figure 7, wherein the said specially designed and dimensioned steel rings (1) form the steel network assembly (1, 2), which is then connected to the reinforcing mesh (3) with plastic clips (2), at the self-compacting concrete block (4) for building structures.

4. A method for installing the protection system according to any one of the patent claims 1 to 3, **characterized in that** comprising connecting microresonators (1), when making an self-compacting concrete block (4) with built-in microresonators (1), by placing the microresonators (1) next to each other, so they form a network in which, each ring (1) faces the same direction, in usual formwork for concrete blocks (4), where, on the lower side, after the protective layer, a reinforcing mesh (3) is placed and microresonators assembly (1, 2) is placed on top of it, in such way the microresonators (1) are interconnected using plastic clips (2), so the steel network assembly (1, 2), which is formed by the interconnection of the microresonators (1), is then connected to the reinforcing mesh (3) in building construction elements, and such built-in assembly (1, 2) of microresonators (1) and reinforcement (3) is filled with self-compacting concrete in the usual known manner.

5. Use of the protection system that is presented according to the patent claims 1 and 2, **characterized in that** the system provides a highly effective protection against electromagnetic radiation, by means of an easy-to-install and economical system for the protection of human health against the influence of electromagnetic fields, with special attention to sensitive groups of society such as children, young people and people with various chronic diseases; and **in that** the system reduces the penetration of electromagnetic radiation into living areas, in such a way that the protection system with microresonators (1) is an integral part of the building structure, for example a wall or a ceiling, and not as an additional coating.
